# FASCICULE DE BREVET EUROPEEN

(11) **EP 1 632 863 B1**
(45) Date de publication et mention de la délivrance du brevet: **25.06.2008**
(21) Numéro de dépôt: 05291779.6
(22) Date de dépôt: 25.08.2005
(51) Int. Cl.: G06F 13/16

(54) **Dispositif programmable d'interface de commande**
Programmierbare Vorrichtung für einer Steuerschnittstelle.
Programmable device for a command interface.

(30) Priorité: 03.09.2004 FR 0409362
(43) Date de publication de la demande: 08.03.2006
(73) Titulaire: STMICROELECTRONICS SA, 92120 Montrouge (FR)
(72) Inventeur: Chalopin, Hervé, 13400 Aubagne (FR); Tabaries, Laurent, 13400 Aubagne (FR)
(74) Mandataire: Verdure, Stéphane

(56) Documents cités:
- EP-A- 0 610 868
- EP-A- 1 213 653
- GB-A- 2 221 328
- US-A1- 2004 054 864

## Description

L'invention se rapporte de manière générale à l'interfaçage de circuit dans un système électronique à processeur. Plus particulièrement, l'invention se rapporte à un dispositif programmable d'interface de commande pour interfacer un circuit esclave nécessitant des commandes complexes.

La complexité des circuits entraîne une complexité de commande. Parmi les circuits nécessitant des commandes complexes, on peut citer les mémoires en circuit intégré, et notamment les mémoires à grande capacité de type E²PROM ou FLASH. Si l'on désire avoir, pour un système à processeur central, un lecteur de mémoire universelle, par exemple pour lire des mémoires de différents type, il est nécessaire d'avoir une interface de commande qui soit compatible avec toutes les mémoires disponibles sur le marché. Une telle interface peut être réalisée actuellement de deux manières différentes.

Une première réalisation consiste à effectuer une gestion logicielle d'un bus d'entrée/sortie standard. Le processeur central commande alors l'état de chaque entrée/sortie reliée à la mémoire qui est reliée à des ports d'entrée/sortie. L'utilisation d'un processeur central pour réaliser ce genre de fonction de manière logicielle nécessite une large utilisation des ressources du processeur. Le processeur central est alors quasiment monopolisé par cette simple gestion des entrées/sorties. De plus, si une interruption provenant du système géré par le processeur central intervient au milieu d'une séquence d'écriture ou de lecture dans ladite mémoire, cette séquence est interrompue, et, dans certains cas, cela peut nécessiter de recommencer intégralement la séquence.

Une deuxième réalisation consiste à utiliser une interface matérielle qui gère elle-même les différentes mémoires possibles. Pour ce faire, l'interface matérielle doit être capable de commander tous les types de mémoire. A cet effet, elle doit disposer de moyens permettant de commander et séquencer chaque type de mémoire. Un inconvénient est que l'évolution des produits ne peut être prise en compte par ce type de circuit. En général, lorsqu'un nouveau circuit à commander, tel que par exemple une nouvelle mémoire, un nouveau micro contrôleur ou tout autre circuit à commandes complexes, arrive sur le marché, l'interface matérielle doit être alors changée.

Le document GB-A-2 221 328 divulgue un émulateur de signaux complexes utilisant des séquences d'états qui représentent un ou plusieurs cycles bus, ou des séquences d'opérations, dans le contexte des testeurs par émulation qui servent à tester les fonctionnalités ou le fonctionnement de systèmes.

L'invention propose une solution aux problèmes précédemment évoqués. Selon l'invention, on réalise une interface de commande programmable pour des circuits nécessitant des commandes complexes. L'interface programmable de l'invention comporte une mémoire mémorisant des commandes échantillonnées et un circuit de séquencement. Le circuit de séquencement est lui-même programmable. Ainsi, avant de débuter une séquence de commande, le processeur charge dans l'interface programmable le séquencement propre à ladite séquence de commandes. Une fois que l'interface de commande est ainsi programmée, le processeur lance le début de la séquence et l'interface programmable de commande peut ensuite gérer de manière autonome la totalité des opérations d'entrées/sorties avec le circuit esclave à commander. La gestion du circuit à commander est alors indépendante de toute interruption propre au système. De plus, l'interface ne nécessite qu'une évolution de type logiciel lorsqu'un nouveau circuit à commander apparait sur le marché.

Selon un premier aspect, l'invention propose un dispositif d'interface de commande programmable selon la revendication 1.

Pour des circuits esclaves nécessitant un gros échange de données, le dispositif comporte, en outre, une deuxième mémoire pour mémoriser des données à destination ou en provenance du circuit esclave, un deuxième compteur d'adresses pour fournir des adresses à ladite deuxième mémoire, le deuxième compteur d'adresses étant contrôlé par la machine d'état programmable.

Suivant un mode de réalisation, la première mémoire est prévue pour mémoriser, en outre, des adresses à destination du circuit esclave. La première mémoire est prévue, en outre, pour mémoriser des mots de commande à destination du circuit esclave.

Suivant un autre mode de réalisation, la deuxième mémoire est prévue, en outre, pour mémoriser des adresses à destination du circuit esclave. La deuxième mémoire est prévue, en outre, pour mémoriser des mots de commande à destination du circuit esclave.

Un autre aspect de l'invention se rapporte à un circuit intégré comportant un dispositif selon le premier aspect ci-dessus.

Selon un autre aspect, l'invention propose un système électronique selon la revendication 13.

Le dispositif et/ou le système sont, par exemple, intégrés dans un circuit intégré, le système étant réalisé sous la forme d'un système sur puce.

L'invention porte aussi sur un procédé de commande d'un circuit esclave selon la revendication 15.

L'invention sera mieux comprise et d'autres particularités et avantages apparaîtront à la lecture de la description qui va suivre, la description faisant référence aux figures annexées parmi lesquelles :
- la figure 1 représente un système à microprocesseur incorporant un dispositif d'interface programmable selon l'invention ;
- la figure 2 représente un exemple de circuit esclave ;
- les figures 3 et 4 représentent deux exemples de séquencement de commandes complexes pour le circuit à commander ;
- les figures 5 à 8 montrent une décomposition de commande élémentaires pour le circuit esclave;
- la figure 9 représente un exemple de séquencement pour une commande complexe :
- la figure 10 représente un exemple de réalisation de la machine d'état programmable selon l'invention ;
- la figure 11 montre la structure d'un mot de la mémoire d'état utilisée dans le circuit de la figure 10 ;
- la figure 12 montre une variante du circuit de la figure 10 ;
- la figure 13 montre la structure d'un mot de la mémoire d'état utilisé dans le circuit de la figure 12 ;

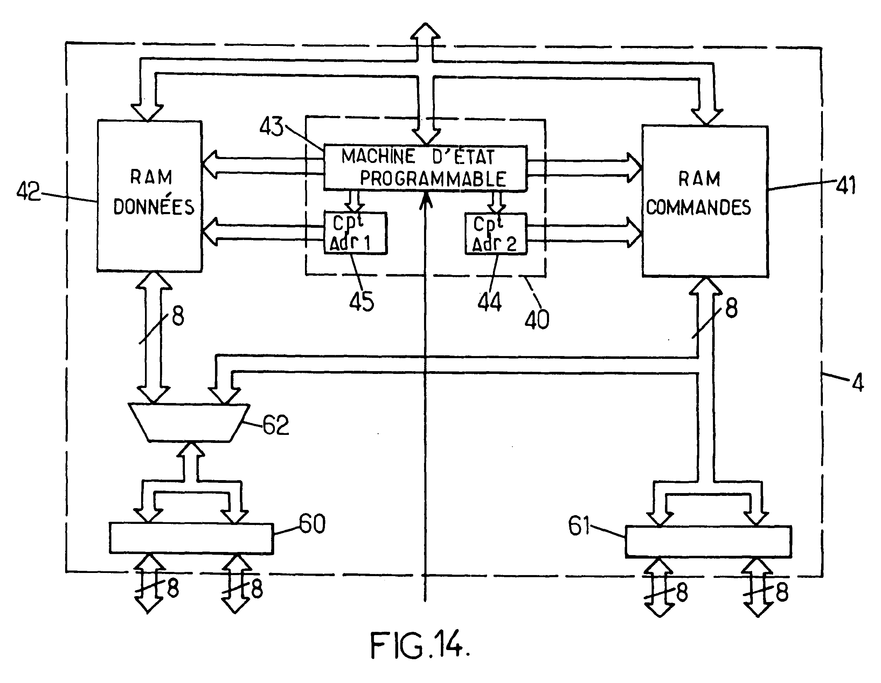

- la figure 14 montre une variante du dispositif d'interface programmable selon l'invention.

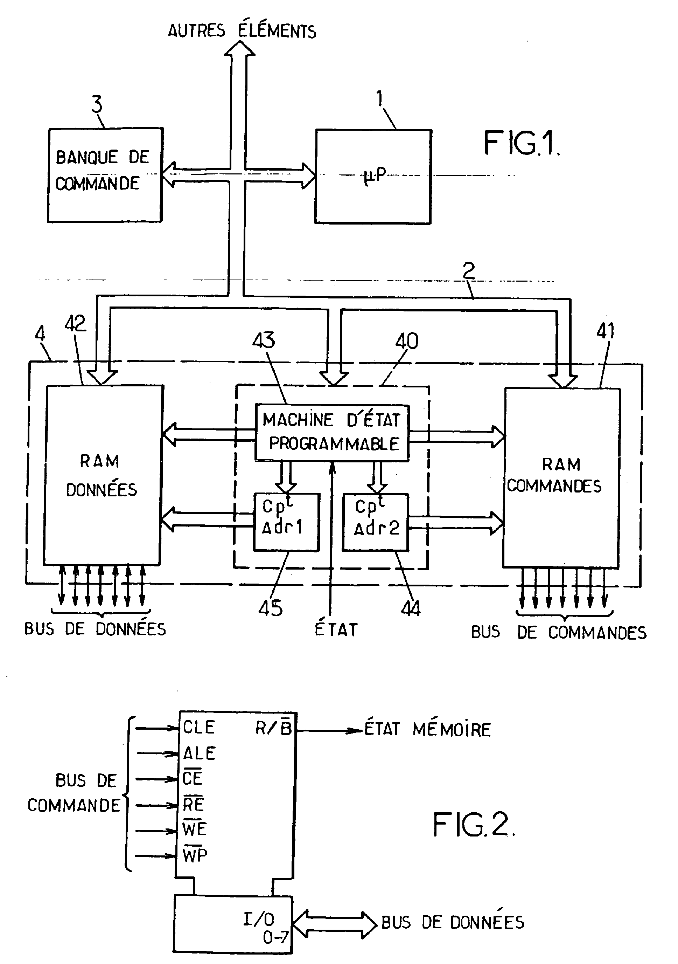

La figure 1 représente un système informatique utilisant un processeur central 1 muni d'un bus central 2. Le système informatique comporte de nombreux éléments non représentés sur la figure mais nécessaires à son bon fonctionnement parmi lesquels on peut citer mémoire vive, interface de visualisation, interface de communication, modem, etc. En ce qui concerne l'invention, il est représentée une banque de commandes 3 qui est en fait une mémoire, soit une mémoire indépendante, soit une mémoire faisant partie de la mémoire centrale du processeur central 1. La banque de commandes 3 comporte toutes les commandes possibles pour tous les circuits esclaves que l'on souhaite connecter à une interface de sortie **4**. La banque de commandes 3 correspond à une banque de commandes d'un système logiciel de l'état de la technique. Selon l'invention, cette banque de commandes 3 est réutilisée avec l'interface programmable de commande 4, objet de l'invention.

Dans l'exemple préféré, représenté sur la figure 1, l'interface programmable de commandes 4 comporte principalement un circuit de contrôle 40, une mémoire de commandes 41 et une mémoire de données 42. Le circuit de contrôle 40, la mémoire de commande 41 et la mémoire de données 42 sont reliés au bus central 2 afin de pouvoir être directement programmés par le processeur central 1. Le circuit de contrôle 40 comporte principalement une machine d'état 43 qui est programmable, un compteur d'adresses de commandes 44 et un compteur d'adresses de données 45. La machine d'état 43 et le compteur d'adresses de commandes 44 pilotent la mémoire de commandes 41 lorsque l'interface programmable de commandes 4 fonctionne de manière autonome. Egalement, la machine d'état 43 et le compteur d'adresses de données 45 assurent le contrôle de la mémoire de données 42. Les compteurs d'adresses de données et de commandes 44 et 45 sont eux-mêmes contrôlés par la machine d'état 43. La machine d'état 43 dispose en outre d'une entrée de signal destinée à recevoir un signal d'état provenant d'un circuit esclave à commander.

La mémoire de commande 41 va contenir des données qui correspondent pour chaque bit à un signal de commandes à envoyer au circuit esclave à commander. Ces données sont chargées directement par le processeur central 1 qui va élaborer la séquence de commandes échantillonnée à enregistrer dans ladite mémoire de commande 41 à partir de la banque de commandes 3 et de l'opération à effectuer sur le circuit esclave. Le processeur central 1 va également programmer le circuit de contrôle 40 afin que la machine d'état 43 puisse correctement contrôler le compteur d'adresses 44 et synchroniser ainsi à l'aide de commandes la mémoire de commandes 41. En outre, le processeur central 1 indique une fréquence de cadencement au circuit de contrôle 40 afin que celui-ci puisse synchroniser les signaux fournis par le bus de commande correspondant au bus de données de la mémoire 41 à une fréquence telle que les signaux de commandes puissent commander les circuits esclaves de manière optimisée. La mémoire de données 42 sert dans le cas où le circuit esclave dispose d'un bus de données pour lire ou écrire des données dans ledit circuit esclave. C'est notamment le cas lorsque le circuit esclave est un circuit de type mémoire à grande capacité, par exemple de type FLASH. Le processeur central 1 ou un dispositif d'accès direct en mémoire (DMA) non représentée va effectuer un transfert de données entre une mémoire ou une interface du processeur central 1 non représentée et la mémoire de données 42. Cette mémoire de données 42 va servir de tampon entre le système informatique et le circuit esclave. Le bus de données de la mémoire de données est utilisé comme bus de données bidirectionnel vis-à-vis du circuit esclave. La machine d'état 43 et le compteur d'adresses 45 contrôlent cette mémoire de données 42. Le processeur central 1 ayant donné au circuit de contrôle 40 des instructions qui concernent également cette mémoire de données 42 simultanément avec les instructions qui concernent la mémoire de commandes 41.

Ainsi, lorsqu'une séquence de commandes doit être envoyée au circuit esclave, par exemple l'écriture d'une page de données dans une mémoire de type FLASH, le processeur central 1 élabore un échantillonnage de commandes à envoyer à partir des éléments présents dans la banque de commande 3 et envoie ladite séquence à la mémoire de commande 41 par l'intermédiaire du bus central 2. Le processeur central 1 commande également un échange de données entre sa mémoire centrale non représentée et la mémoire de données 42. Ce processeur central 1 fixe la fréquence de cadencement du circuit de contrôle 40 et donner les instructions nécessaires à la machine d'état programmable 43 pour que celle-ci assure le contrôle, d'une part, de la mémoire de commandes 41 et, d'autre part, la mémoire de données 42 lors de la réalisation de la commande complexe du circuit esclave.

La figure 2 représente un exemple de circuit esclave. Ce circuit esclave est par exemple une mémoire FLASH de 64 méga octets. Ce type de mémoire est communément utilisée comme mémoire de masse, et sert dans de nombreuses applications, telle que par exemple appareil photo, appareil d'enregistrement et de lecture de musique numérique et aussi caméra, etc. Ce type de mémoire présente comme principal avantage d'être une mémoire de masse peu encombrante. Par contre, un inconvénient de ces mémoires provient de leur lenteur par rapport à une mémoire volatile de type RAM. Ce type de mémoire pour des raisons de rapidité d'adressage mais également pour des raisons physiques est divisé en une pluralité de groupes. Parmi lesquels groupes, la mémoire comporte, par exemple, quatre zones de mémoire, chaque zone de mémoire comportant elle-même 1024 blocs. Chaque bloc comportant 32 pages. Et chaque page étant divisée en deux plans de données comportant chacun 256 octets, auquel il faut ajouter un plan redondant de, par exemple, 16 octets qui sert à enregistrer une signature des données comprises dans le reste de la page.

Afin d'accélérer les transferts de données entre ce type de mémoire et un système l'utilisant, des instructions complexes s'adressent non plus à une donnée mais un groupe de données qui peut être de taille variable. Les instructions vont s'adresser soit à une donnée, soit à une page ou à un morceau de page, soit à un bloc et à une zone ou qu'à une pluralité de zone de ladite mémoire. De plus, afin de limiter le nombre de connexion entre le circuit de mémoire et un circuit l'utilisant, des mots d'instruction, d'adresse et de donnée sont multiplexées sur un même bus. Dans l'exemple montré sur la figure 2, le circuit esclave dispose de première à sixième entrées de commandes, d'une sortie d'état, et d'un bus de données, par exemple de bus de 8 bits, noté ici I/O₀₋₇.

La première entrée du circuit esclave reçoit un signal de validation de commandes CLE (de l'anglais Command Latch Enable). La deuxième entrée reçoit un signal de validation d'adresses ALE (de l'anglais Address Latch Enable). La troisième entrée reçoit un signal de validation de circuit C̅E̅ (de l'anglais Chip Enable). La quatrième entrée reçoit un signal de validation de lecture R̅E̅ (de l'anglais Read Enable). La cinquième entrée reçoit un signal de validation d'écriture W̅E̅ (de l'anglais Write Enable). La sixième entrée reçoit un signal de protection en écriture W̅P̅ (de l'anglais Write Protected). La sortie d'état fournit un détail de disponibilités R/B̅ (de l'anglais Ready/Busy). Le signal de disponibilités R/B̅ indique, suivant son état, si la mémoire est disponible ou si celle-ci est indisponible. Le bus de données I/o₀₋₇ est un bus bidirectionnel destiné à recevoir et à fournir des données mais également destiné à recevoir des adresses ainsi que des mots de commandes correspondant à des commandes complexes.

Un tel circuit dispose par exemple d'un jeu de commandes complexes tel qu'indiqué dans le tableau suivant :

**TABLEAU DE COMMANDES**

| COMMANDE | 1^{er} MOT | 2^{ème} MOT | 3^{ème} MOT |
|---|---|---|---|
| Lecture A | 00h/01h | | |
| Lecture B | 50h | | |
| Lecture ID | 90h | | |
| Initialisation | FFh | | |
| Programmation de page Multiple | 80h | 10h | |
| Programmation de page Simple | 80h | 11h | |
| Recopie de page Multiple | 00h | 8Ah | 10h |
| Recopie de page Simple | 03h | 8Ah | 11h |
| Effacement de Bloc | 60h | D0h | |
| Effacement de Bloc multiple | 60h...60h | D0h | |
| Lecteur Etat | 70h | | |
| Lecteur Etat multiple | 71h | | |

Dans ce tableau, on peut voir qu'il y a trois commandes de lecture dont une qui dispose de deux mots de commandes. Ainsi l'instruction Lecture A est une lecture à partir d'une adresse sur une certaine longueur n'excédant pas, par exemple une page de mémoire. L'utilisation de deux codes 00h et 01 h (le « h » signifiant un nombre hexadécimal) sert à adresser de manière indépendante chaque plan d'une page. L'instruction Lecture B, codée 50h, sert à lire le plan redondant seul. Une Lecture de 528 octets successifs à partir de la première adresse du premier plan fournira les 256 octets du premier plan, les 256 octets du deuxième plan, puis les 16 octets du plan redondant. L'instruction Lecture ID, codée 90h, sert à lire des données d'identification propres au circuit de mémoire qui sont, par exemple le numéro de série du composant, son numéro de fabrication, l'usine de fabrication, etc. Une instruction d'Initialisation, codée FFh, est également disponible. Des instructions de Programmation de pages, codées 80h + 10h/11h, de Recopie d'une page d'un bloc vers un autre bloc de la mémoire, codées 00h/03h + 8Ah + 10h/11h, d'Effacement d'un bloc, codées 60h + D0h, peuvent être réalisées de manière simple ou de manière multiple, c'est-à-dire enchaînée. Des instructions qui permettent également la lecture de l'état, codées 70h/71 h, de la mémoire sont disponibles pour savoir si tout s'est bien passé après une ou plusieurs opérations d'écriture ou d'effacement.

Les commandes complexes peuvent comporter un seul mot de commande, c'est le cas notamment des commandes de lecture ainsi que de la commande de réinitialisation de la mémoire. Mais deux ou trois mots de commande peuvent également être nécessaire comme on peut le voir sur le tableau. A ces mots de commandes, il faut ajouter les adresses, dont la taille varie suivant ce qui est adressé, adresse simple, page ou bloc, ainsi que les données si il y a lieu. De plus, lorsque des commandes successives s'adressent à plusieurs zones de la mémoire, celles-ci peuvent être gérées de manière enchaînée pour gagner en rapidité. Toute commande complexe est divisée en commandes élémentaires directement contrôlées par les première et sixième entrées de la mémoire. Ces commandes élémentaires permettent d'écrire un mot de commande, d'adresse ou de donnée dans la mémoire et permettent aussi la lecture de la mémoire.

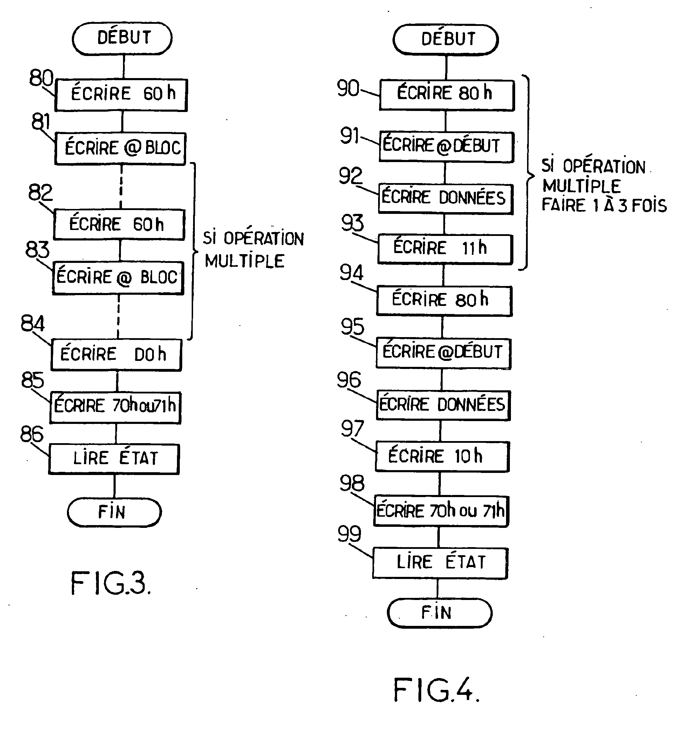

La figure 3 représente le déroulement d'une instruction complexe destinée à effacer un ou plusieurs blocs dans la mémoire. Au cours d'une étape 80, la mémoire doit être commandée pour écrire le mot correspondant à la commande d'effacement de blocs, par exemple 60h. Cette commande étant écrite dans la mémoire, il convient ensuite d'écrire l'adresse du bloc à effacer au cours d'une étape 81. Si plusieurs blocs doivent être effacés, les étapes, 82 et 83 sont répétées autant de fois qu'il y a de blocs à effacer, les étapes 82 et 83 étant de même nature que les étapes 80 et 81. Une cinquième étape 84 écrit le deuxième mot de commande de l'instruction d'effacement de blocs D0h, indiquant que les instructions de commande d'effacement de blocs sont terminées et que la mémoire peut alors procéder à l'effacement physique desdits blocs. A l'issue de cette commande et afin de savoir si l'effacement s'est correctement déroulé, il est possible d'enchaîner une lecture d'état. L'étape 85 consiste à écrire la commande de lecture d'état simple 70h ou multiple 71 h si plusieurs instructions d'effacement de blocs successifs ont été faites. Cette commande ayant été écrite, il convient de lire les données ressortant de la mémoire au cours de l'étape 86.

Si l'on désire écrire des données à l'intérieur de la mémoire, on a recours à des instructions de programmation et notamment de programmation de pages. Ces instructions de programmation de page peuvent également être enchaînées sur plusieurs zones de mémoire et correspondre à différentes adresses.

La figure 4 illustre le déroulement d'une commande complexe où l'on écrit au moins deux pages de la mémoire. Au cours d'une étape 90, on écrit le mot de commande 80h correspondant au début de l'instruction de programmation. Au cours d'une étape 91, on écrit l'adresse où commence le début d'écriture de la page. Au cours d'une étape 92, on fournit les données à la mémoire. Le nombre de données fournies doit être au plus égal au nombre de données restant à écrire dans la page à partir de l'adresse de début d'écriture, en incluant les deux plans de la page et le plan redondant. Au cours d'une étape 93, on écrit le deuxième mot de commande de l'instruction de programmation 11h qui ici indique qu'il va être suivi par une deuxième opération de programmation. Si l'on effectue une programmation dans plus de deux zones, on répète les étapes 90 à 93. Au cours d'une étape 94, on écrit le mot de commande 80h correspondant à la programmation de la dernière page. L'étape 95 permet d'écrire l'adresse de début d'écriture dans la page considérée. L'étape 96 consiste à écrire les données dans la mémoire. L'étape 97 écrit le deuxième mot de commande 10h qui correspond, d'une part à la dernière opération de programmation et également au lancement de l'opération interne de la mémoire de programmation elle-même. Celle-ci clôture l'opération d'écriture. Pour vérifier le bon déroulement de l'écriture, une étape 98 indique à la mémoire que l'on réalise une lecture d'état. Le mot 70h ou 71 h utilisé est choisi suivant le nombre de pages écrites. Une étape 99 sert à lire les données sortantes correspondant à l'état demandé.

Comme on peut le remarquer, ces étapes complexes nécessitent la réalisation d'une pluralité d'étapes élémentaires d'écriture de commandes, d'écriture d'adresses, d'écriture de données ou de lecture de données. Ces étapes élémentaires sont réalisables directement avec les signaux de commandes envoyées sur les première à sixième entrées de ladite mémoire.

Les différentes étapes élémentaires correspondant à tous les cas de figures possibles sont enregistrées dans la banque de commandes 3. Cette banque de commande va comporter les étapes élémentaires d'une pluralité de type de circuits esclaves à commander et notamment la mémoire citée dans l'exemple.

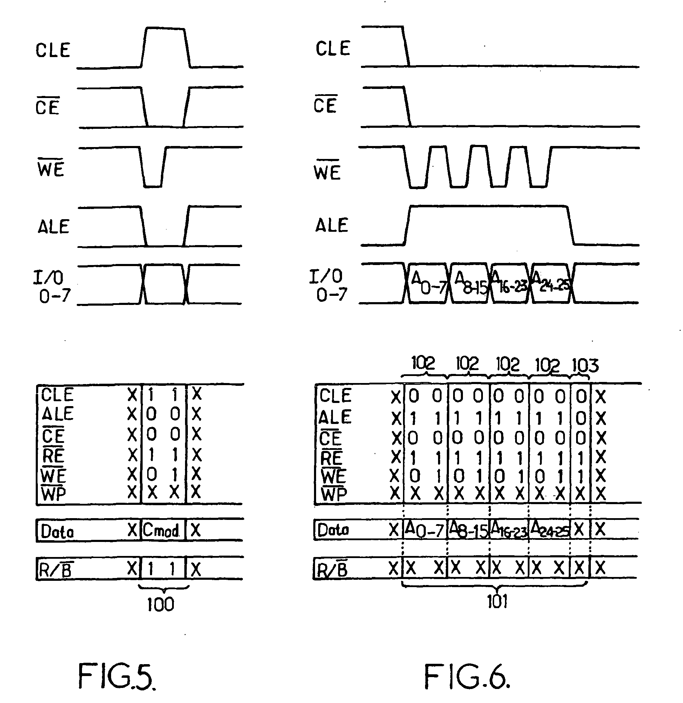

La figure 5 représente les signaux à envoyer sur les entrées de commandes de la mémoire pour écrire un mot de commande. Ces signaux sont dictés par les informations sur la mémoire en question données par le constructeur. Ainsi que des impératifs notamment temporels sur les différentes durées à utiliser. Dans le cas de ce circuit de mémoire, l'observation des différentes temporisations à utiliser montre que un temps, par exemple de 25 nano-secondes (ns), peut correspondre à une durée minimale pour effectuer un changement d'état sur un signal. Pour écrire un mot de commande, il est nécessaire que le signal de validation de commandes CLE soit à 1 pendant cette écriture. Il est également nécessaire que le circuit esclave soit sélectionné comme étant actif et cela nécessite donc que le signal de validation de circuit C̅E̅ soit dans un état actif, par exemple un état bas. Le signal d'écriture W̅E̅ va également être utilisée afin d'inscrire un mot dans la mémoire à partir du bus de données I/O₀₋₇. L'écriture en elle-même se fait sur un front montant du signal de validation d'écriture W̅E̅ . Ainsi, pendant l'étape d'écriture de commandes, il est nécessaire d'avoir un front montant de ce signal d'écriture W̅E̅ . Le signal de validation d'adresses ALE doit quant à lui être mis dans un état bas. Le signal de validation de lecture R̅E̅ doit rester inactif et être dans notre exemple maintenu au niveau 1. Le signal de protection en écriture W̅P̅ peut être dans n'importe quel état. Celui-ci, en effet sert essentiellement à s'assurer que lors d'une mise sous tension du circuit, la mémoire ne s'efface pas accidentellement.

L'étape d'écriture de commandes nécessite que la mémoire soit disponible ainsi, le signal de disponibilité R/B̅ de ladite mémoire doit être positionné à 1 pour que cette étape puisse se faire. Ces commandes en vertu des données du constructeur de la mémoire sont donc échantillonnées à 25 ns.

Chaque signal est décomposé en une séquence 100 constituée de 2 bits. Au cours de cette séquence 100, seul le signal de validation en écriture W̅E̅ doit passer de 0 à 1. Pour ce qui est de l'état des signaux avant et après cette commande, ceux-ci vont dépendre essentiellement de l'événement se produisant avant ou après. Le processeur central 1 ira donc chercher dans la banque de commandes 3, les données correspondant aux signaux de commandes qu'il va charger dans la mémoire de commandes 41. Ces données vont correspondre à la succession de bits montrés sur cette figure 5. Par contre le mot de commande pouvant changer suivant le type de commande à effectuer, le processeur central 1 inscrit, par exemple dans la mémoire de données 42, le mot de commande souhaité. Le circuit de commandes 40 sera quant à lui positionné de manière à effectuer le séquencement consistant à sortir deux fois des données de la mémoire de commandes 41 alors qu'il ne sortira qu'une seule fois le mot de commande de la mémoire 42.

La figure 6 montre comment doit se passer un séquencement d'une écriture d'adresse. Avant le début d'écriture d'adresse, les signaux sont positionnés dans un état qui dépend de ce qui a été précédemment envoyé. Pour écrire une adresse, il convient que le signal de validation de commandes CLE soit inactif, par exemple à l'état bas, que le signal de validation de circuit C̅E̅ soit actif, par exemple à l'état bas, que le signal de validation d'écriture W̅E̅ change de front autant de fois qu'il y a de mot d'adresse à envoyer. Il convient également que le signal de validation d'adresses ALE soit actif lorsque le signal d'écriture va changer d'état pour passer d'un état bas à un état haut et inscrire ainsi le mot d'adresse qui sera présente sur le bus de données I/O₀₋₇. Le signal de lecture R̅E̅ quant à lui doit rester inactif, par exemple à l'état haut, et le signal de protection en écriture W̅P̅ peut être dans n'importe quel état. Au cours de cette phase d'écriture d'adresse, il n'est pas nécessaire que cette mémoire soit disponible ou pas, ainsi il n'est pas important de tenir compte du signal de disponibilité R/B̅ de la mémoire. Dans le cas de notre mémoire disposant de 64 Mégaoctets accessibles par octet, l'adresse se compose de 26 bits. Or, la mémoire ne dispose que d'un bus de données I/O₀₋₇d'uniquement 8 bits. L'adressage est donc réalisé par l'écriture successive de trois ou quatre mots d'adresse suivant l'adressage à effectuer. Ainsi, il est possible de décomposer une séquence d'adressage 101 de quatre mots en quatre sous-séquences 102 destinées à écrire chacune un mot différent de l'adresse dans la mémoire. Egalement, en fin d'adressage, il est nécessaire d'indiquer que l'adressage est fini et donc de remettre le signal de validation d'adresses ALE à zéro au cours d'une sous-séquence 103. Ainsi, pour écrire une adresse complète constituée de quatre mots d'adresses, et considérant l'échantillonnage fait des commandes, il est nécessaire de disposer de neuf cycles de commandes. La banque de commandes 3 va mémoriser les sous-séquences 102 et la sous-séquence 103 et lorsque le processeur va inscrire dans la mémoire de commandes 41 les commandes à réaliser, celui-ci va recomposer la séquence complète d'adressage 101 à partir de la banque de commandes et va, par exemple dupliquer les sous-séquences 102 autant de fois que nécessaires. Par ailleurs, les mots d'adresses vont être écrits dans la mémoire de données 42.

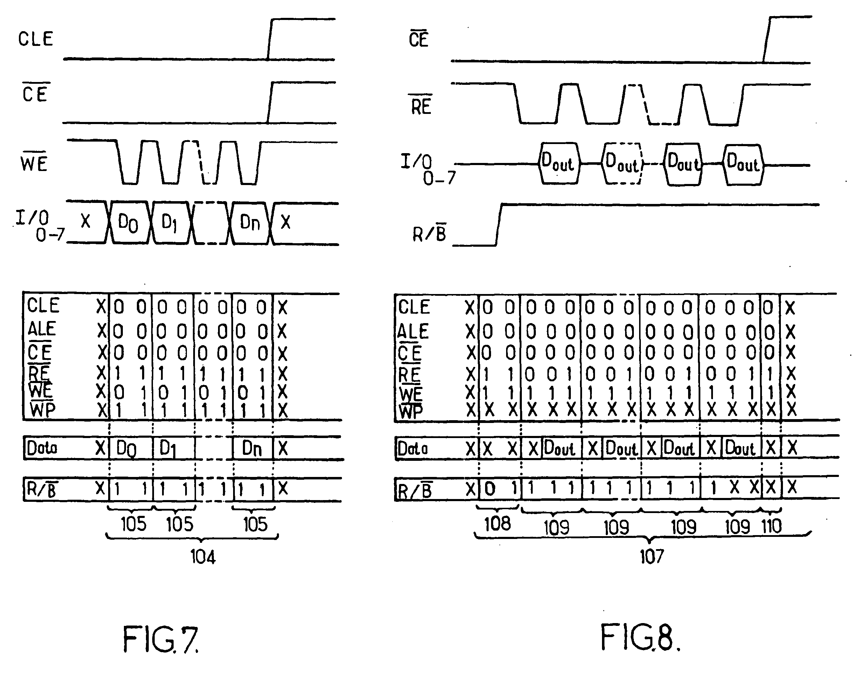

La figure 7 représente le cas d'écriture de données relativement similaire à une écriture d'adresse si ce n'est que généralement cette écriture de données se clôture par une mise en indisponibilité de la mémoire et que cette séquence de données doit être envoyée uniquement si la mémoire est disponible. Cette séquence d'écriture de données 104 est composée d'une pluralité de sous-séquences 105 visant chacune à écrire une donnée dans la mémoire. La donnée étant écrite sur le front montant du signal d'écriture W̅E̅ Les sous-séquences 105 sont répétées autant de fois qu'il y a de données à écrire.

La figure 8 représente une étape de lecture de données. La lecture de données quant à elle se fait lorsque le signal de validation d'écriture W̅E̅ est inactif, par exemple au niveau 1, que le signal de validation de commandes CLE et le signal de validation d'adresses ALE sont également inactifs, par exemple au niveau 0. Durant l'écriture, le signal de lecture R̅E̅ valide sur un front descendant la demande de données suivantes. Cette opération est répétée autant de fois que l'on désire sortir de données de la mémoire. Le temps de latence entre la validation de la donnée suivante et l'arrivée de cette donnée est généralement variable en fonction de la mémoire et des tensions d'alimentation. Le constructeur indique une durée maximale qui, dans cet exemple excède les 25 ns. A cet effet, une sous-séquence de lecture 109 de données est échantillonnée sur trois périodes de 25 ns et correspond à trois bits pour chaque commande.

La séquence de lecture 107 comporte au début une sous-séquence d'attente 108. Durant cette sous-séquence d'attente 108, les signaux de commandes restent stables en attendant que le signal de disponibilité R/B̅ passe au niveau 1. Tant que le signal de disponibilité R/B̅ est de niveau bas, cette sous-séquence d'attente 108 bloque l'opération à effectuer. Une fois que le signal de disponibilité R/B̅ passe à l'état haut, on déclenche les sous-séquences de lecture 109 de données proprement dite. Comme on l'a dit précédemment, cette sous-séquence 109 est échantillonnée sur trois périodes de 25 ns pour avoir la certitude qu'une donnée sera présente sur le bus de données I/O₀₋₇ avant le milieu de la deuxième période de la sous-séquence 109. Ainsi, l'entrée des données dans la mémoire des données 42 peut se faire lors de la transition entre la deuxième et la troisième période de chaque sous-séquence. Les sous-séquences 109 sont répétées jusqu'à l'obtention de la dernière donnée souhaitée. A l'issue de la sous-séquence 109, une sous-séquence de fin 110 est ajoutée. Cette sous-séquence de fin 110 correspond à la remise à disponibilité de ladite mémoire. Là aussi, le processeur central 1 va aller chercher dans la banque de commandes 3 les sous-séquences élémentaires 109 et 110 qu'il va enregistrer dans la mémoire de commandes 41 et va indiquer le séquencement à suivre au circuit de commandes 40. Une fois que l'opération des transferts de données est terminée, les données se trouveront mémorisées dans la mémoire de données 42. Le processeur central 1 pourra alors effectuer ou demander à un circuit d'accès direct en mémoire d'effectuer le transfert depuis cette mémoire de données 42 vers une mémoire centrale du système informatique non représentée.

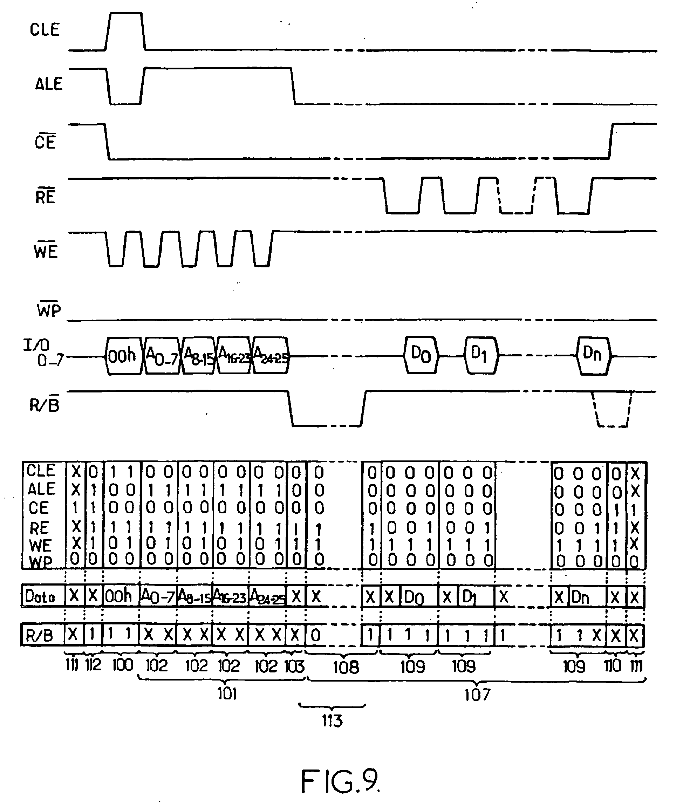

A titre d'exemple, la figure 9 illustre une opération complexe de lecture. En plus des séquences correspondant aux commandes élémentaires précédemment vues avec les figures 5 à 8, des sous-séquences supplémentaires doivent être ajoutées afin que la mémoire soit correctement pilotée et que les opérations soient correctement initialisées et terminées. Ainsi, une sous-séquence 111 est une séquence d'attente qui sera positionnée en sortie du circuit de commandes indiquant que la mémoire n'est pas utilisée. Le seul signal de commande important étant que le signal de validation de circuit C̅E̅ soit mis à un état inactif 1. Les autres signaux peuvent être dans n'importe quel état. Préalablement à l'envoi d'une commande, il convient par contre de positionner tous les signaux dans un état de début d'opération, c'est ce qui fait la sous-séquence 112 d'initialisation. Le signal de validation de circuits C̅E̅ restant toujours inactif, les autres signaux de commandes vont être positionnées dans des états les rendant tous inactifs afin d'initialiser correctement la commande complexe. Dans le cas d'une lecture de données, la commande 00h est envoyée à l'aide d'une séquence 100 d'écriture de commande. Une séquence 101 d'adressage est ensuite envoyée. Cette séquence d'adressage est immédiatement suivie d'une séquence 107 de lecture de données. L'homme du métier pourra remarquer que pendant une période 113 dont la durée n'est pas fixée par le séquenceur, l'interface programmable de commandes 4 est en situation d'attente vis-à-vis du signal de disponibilité R/B̅ Bien que la durée de la période 113 ne soit pas contrôlable, la sous-séquence 108 va assurer un maintien d'état tant que ce signal de disponibilité n'indiquera pas que la mémoire est prête à sortir les données. A l'issue de la lecture des données, une sous-séquence 111 de mise en attente de la mémoire est utilisée.

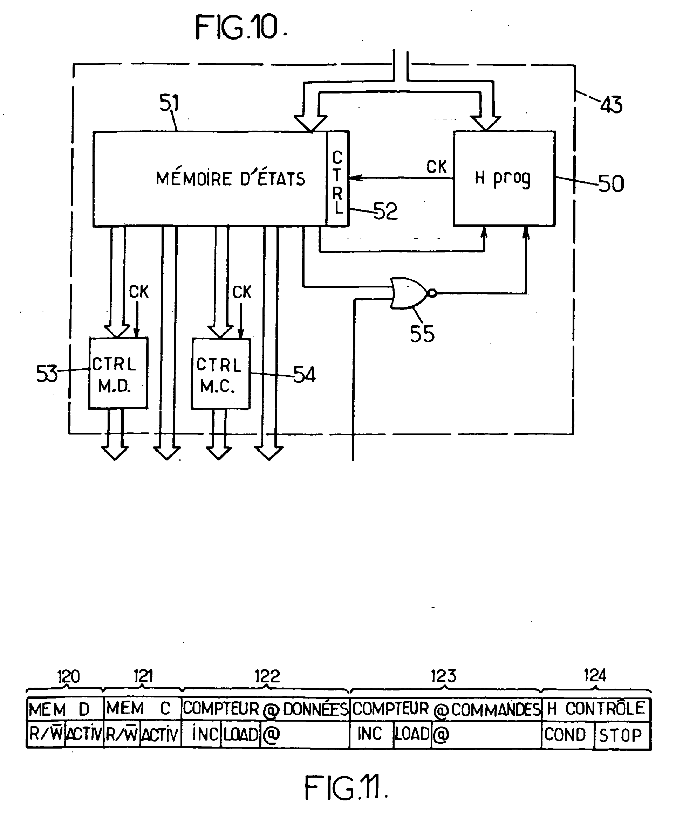

Afin de réaliser un séquencement correct des différentes opérations à déclencher à l'aide de la mémoire de commandes 41, la machine d'état 43 doit mémoriser les différents états permettant de faire succéder les différentes opérations. Pour cela, on utilise par exemple la machine d'état programmable 43, représentée sur la figure 10. Cette machine d'état 43 comporte principalement une horloge programmable 50, une mémoire d'état 51 contrôlée par un contrôleur de mémoire 52 lui-même piloté un signal d'horloge CK provenant de l'horloge programmable 50. Le contrôleur de mémoire 52 est, par exemple un compteur qui va incrémenter de manière linéaire les adresses de la mémoire d'état en fonction du signal d'horloge. La mémoire d'état 51 est lue de manière linéaire. Deux générateurs de commandes 53 et 54 vont décoder des bits reçus de la mémoire d'état pour les transformer en commandes élémentaires pour, respectivement, la mémoire de données 42 et la mémoire de commandes 41. Ces générateurs de commandes 53 et 54 sont synchronisés également par le signal d'horloge CK. Un circuit de neutralisation 55, par exemple une porte NOR reçoit, d'une part le signal de disponibilité R/B̅ de la mémoire et, d'autre part un bit de contrôle provenant de la mémoire d'état 51. La mémoire d'état 51 fournit également un bit de contrôle à l'horloge programmable 50 et fournit des commandes aux compteurs d'adresses de commandes 44 de données 45.

Les circuits générateurs de commandes 53 et 54 ainsi que le contrôleur de mémoire 52 doivent piloter des mémoires de type RAM à une vitesse supérieure à la période d'échantillonnage des signaux. De manière générale, il est nécessaire d'avoir un signal d'horloge CK dont la fréquence est au moins 3 fois supérieure à la fréquence d'échantillonnage réel. A titre d'exemple, le signal d'horloge est choisi avec un rapport trois par rapport au signal d'échantillonnage, ce qui correspond à une fréquence de 120 MHz.

La mémoire d'état 51 est une mémoire dont l'architecture permet de mémoriser des mots de grande dimension. Ces mots de grande dimension vont comporter une pluralité de bits d'état ainsi que des adresses de chargement des compteurs d'adresses de commandes 44 et de données 45. L'architecture d'un mot de cette mémoire d'état 51 est représentée sur la figure 11. Le mot comporte des bits de contrôle de mémoire de données 120, des bits de contrôle des mémoires de commandes 121, des bits de contrôle du compteur de donnée 122, des bits de contrôle du compteur de commande 123 et des bits de contrôle de l'horloge 124. Les bits de contrôle de mémoires de données 120 ou de commandes 121 comportent, par exemple, un bit R/W̅ indiquant si la mémoire doit fonctionner en mode de lecture ou en mode d'écriture et un autre bit ACTIV indiquant si la mémoire doit être active ou inactive. Les deux bits sont ensuite envoyés au circuit générateur de commandes 53 et 54 afin d'être traduit en commande propre pour ladite mémoire. Les bits de contrôle de compteurs de données 122 et de commandes 123 vont être composés, d'une part d'un bit d'incrémentation INS, d'un bit de chargement LOAD et de l'adresse @ à charger dans ledit compteur. Les bits de contrôle de l'horloge 124 sont, par exemple, un bit conditionnel COND qui combiné avec le signal d'état provenant de la mémoire va ou non bloquer l'horloge 50. Ce bit conditionnel, quand il est dans un premier état va valider le signal d'état de la mémoire et quand il est dans un autre état, va l'invalider. La validation ou l'invalidation du bit de disponibilité de la mémoire ou plus généralement du bit d'état du circuit esclave va faire que l'horloge peut être bloquée ou non bloquée par ledit bit d'état. Parmi les bits de contrôle de l'horloge, un bit d'arrêt STOP sert à stopper l'horloge de manière définitive, par exemple lorsque le déroulement de la commande complexe est terminé. Simultanément, le changement d'état de ce bit d'arrêt peut déclencher une interruption à destination du processeur pour lui indiquer que la commande complexe qu'il avait demandée est réalisée.

Avec une telle machine d'état 43, le processeur central 1 doit inscrire dans la mémoire d'état 51 tous les mots nécessaires au bon déroulement du séquencement. Si l'on considère le nombre et la longueur des mots à mémoriser, cette opération d'enregistrement des différents états dans la mémoire d'état 51 est relativement longue. Même si cette opération peut être interrompue de nombreuses fois par d'autres éléments du système informatique, il n'en est pas mois que cette opération va requérir de la part du processeur central une certaine occupation. Cette solution permet cependant de réduire fortement l'occupation du processeur central lorsque plusieurs instructions complexes d'un même type sont exécutées successivement. A titre d'exemple, le transfère de données maximal, réalisable avec une instruction de lecture ou d'écriture, porte sur 2 kilo-octets, si le processeur central 1 désire transférer un volume de données plus important, il devra répéter cette opération autant de fois que nécessaire. Il suffit alors de changer uniquement les adresses des groupes de données, ce qui est très rapide.

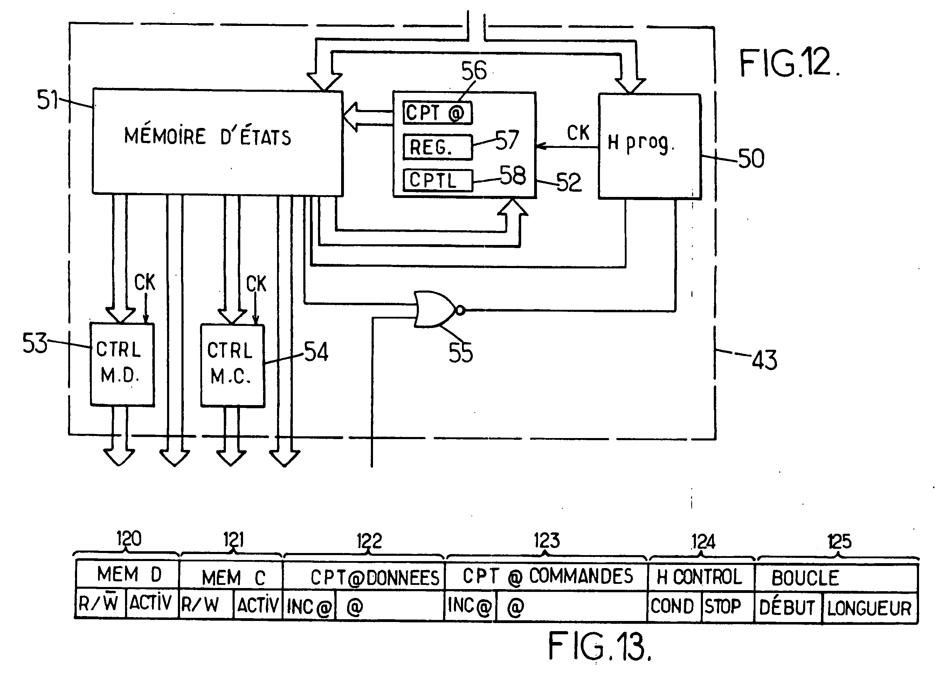

Afin de réduire le temps de programmation de l'interface programmable 4 par le processeur central 1 et afin de réduire la taille de la mémoire d'état 51, une variante est proposée sur la figure 12. Cette variante vise à ne mémoriser dans la mémoire d'état 51 qu'un nombre réduit de séquences élémentaires. Les séquences élémentaires qui sont répétées de manière successive le sont par l'intermédiaire de boucles. A cet effet, le contrôleur de mémoire 52 dispose d'un compteur d'adresses d'état 56, d'un registre de boucle 57 et d'un compteur de boucle 58. La mémoire d'état 51 va mémoriser également des bits de contrôle de boucles 125 à destination du contrôleur de mémoire 52. Les bits de contrôle de boucles 125, montrés sur la figure 13, sont ajoutés dans la structure de mots de la mémoire d'état 51. Ainsi, lorsqu'une séquence élémentaire, par exemple une sous-séquence d'écriture d'adresse 102 ou d'une sous-séquences d'écriture 105 ou de lecture 109 de données, est réalisée de manière répétitive, en l'occurrence trois ou quatre fois pour les adresses et jusqu'à 528 fois pour les données, une seule sous-séquence sera mémorisée dans la mémoire d'état 51 et de commande 41. Pour pouvoir effectuer de manière répétitive la sous-séquence, les bits de contrôle de boucles vont être activées. Ainsi, au début de chaque sous-séquence, un bit de début de séquence va être activé. Lorsque ce bit est activé, le registre de boucle 57 va mémoriser l'adresse du compteur d'adresse 56, et le compteur de boucle 58 va être initialisé à un. Le dernier mot de la mémoire d'état 51 qui va correspondre à la fin de la sous-séquence va quant à lui mémoriser la longueur de la boucle en terme de nombre de répétitions. Cette longueur de boucle va être comparée à la sortie du compteur de boucles 58. Si le compteur de boucles contient un résultat inférieur à la longueur de boucle, alors le compteur d'adresses 56 est repositionné à la valeur mémorisée dans le registre de boucle 57 et le compteur de boucle 58 va s'incrémenter. Si la sortie du compteur de boucle 58 est égale à la longueur de boucle, alors la boucle est terminée. Ainsi, si l'on a par exemple 200 données à écrire, la mémoire d'état ne va mémoriser qu'une seule sous-séquence d'écriture de données qui sera répétée 200 fois. Il conviendra de positionner le compteur de donnée 42 avant le début de la boucle. L'incrémentation du compteur de donnée 42 se faisant en fin de boucle.

L'interface de commandes à été décrite en relation avec une mémoire de type FLASH disposant de mots de données de 8 bits et ainsi que de six entrées de commandes. Il va de soi que l'interface ne se limite à commander une unique mémoire mais peut s'adresser à une pluralité de circuit. A cet effet, le bus de commandes correspondant à la sortie de la mémoire de commandes 41 peut comporter bien plus de 6 bits. Da manière générale les mémoires sont organisées en mot de 8 ou 16 bits. Il est tout à fait concevable d'avoir des mémoires de commandes 41 et de données 42 architecturées avec des mots de 8 bits tout en disposant de bus de commandes et de bus de données de 16 bits, par exemple en ajoutant des tampons de données 60 et 61. Dans ce cas là, les mémoires de commandes 41, données 42 et d'état 51 devront être cadencées deux fois plus vite. Etant donné que les circuits de mémoires utilisés dans l'interface programmable 4 sont des circuits de mémoire vive beaucoup plus rapides que les mémoires mortes de type FLASH ou E²PROM utilisant des commandes complexes, ces mémoires peuvent être cadencées à des fréquences très supérieures.

Dans l'exemple précédemment décrite, les adresses, les commandes et les données sont toutes mémorisées dans la mémoire de données 42. Cela nécessite d'avoir une mémorisation dans la machine d'état 43 de l'endroit où se trouvent, les commandes, les adresses et les données. Afin de simplifier la machine d'état 43 et donc de lui éviter de mémoriser systématiquement ces adresses là, il est possible de supprimer les sauts d'adresses dans la mémoire de données 42 en mémorisant uniquement les données dans la mémoire de données 42 à partir d'une première adresse prédéfinie. Dans ce cas là, la mémoire d'état peut être réduite en supprimant les bits d'adressage du compteur de donnée. Les commandes et les adresses sont alors stockées dans la mémoire de commandes. Il convient alors de multiplexer le bus de la mémoire de commandes et le bus de la mémoire de données afin que sur l'entrée/sortie de données on puisse soit échanger des données avec la mémoire de données 42, soit fournir les mots de commandes et des adresses depuis la mémoire de commandes 41. Un tel circuit est représenté sur la figure 4 qui comporte, d'une part un multiplexeur 62 destinés à multiplexer les données sortant de la mémoire de commandes 41 avec les données entrant ou sortant de la mémoire de données 42. Les données sont multiplexées de manière bidirectionnelle pour autoriser le transfert de données dans les deux sens entre la mémoire de données 42. Des tampons 60 et 61 sont rajoutées afin de doubler la taille des mots de la mémoire de données 42 et de la mémoire de données 41 si cela est nécessaire pour commander des circuits plus complexes disposant soit d'un bus d'entrée/sortie de données de 16 bits, soit disposant d'un nombre de signaux de commandes supérieurs à 8 bits et pouvant aller jusqu'à 16 bits.

L'interface programmable 4 qui vient d'être détaillée peut être réalisée sur un circuit intégré. Il est également possible qu'un seul circuit intégré inclue le système informatique incluant l'interface programmable 4.

## Revendications

1. Dispositif d'interface de commande programmable (4) pour la commande d'un circuit esclave par un système ayant au moins un processeur central (1) et une mémoire (3) dans laquelle tout signal de commande (CLE, ALE, C̅E̅, R̅E̅, W̅E̅, W̅P̅) destiné à commander le circuit esclave est décomposé en une succession de bits correspondant à un échantillonnage dudit signal à l'aide d'un signal d'échantillonnage dont la période est au plus égale à la plus petite durée entre deux changements d'état d'un signal de commande, le dispositif comportant :
- une première mémoire (41) adaptée pour mémoriser, sous la commande du processeur, une séquence de commandes échantillonnées élaborée par le processeur en fonction de l'opération à effectuer dans le circuit esclave à partir des éléments présents dans la mémoire du système,
- un premier compteur d'adresses (44) pour fournir des adresses à ladite première mémoire (41),
- une machine d'état programmable (43) pour contrôler la première mémoire (41) et le premier compteur d'adresse (44) de manière à commander le circuit esclave.

2. Dispositif selon la revendication 1, qui comporte, en outre :
- une deuxième mémoire (42) pour mémoriser des données à destination ou en provenance du circuit esclave,
- un deuxième compteur d'adresses (45) pour fournir des adresses à ladite deuxième mémoire (42), le deuxième compteur d'adresses (45) étant contrôlé par la machine d'état programmable (43).

3. Dispositif selon l'une des revendications 1 ou 2, dans lequel la première mémoire (41) est adaptée pour mémoriser, en outre, des adresses à destination du circuit esclave.

4. Dispositif selon l'une des revendications 1 à 3, dans lequel la première mémoire (41) est adaptée, en outre, pour mémoriser des mots de commande à destination du circuit esclave.

5. Dispositif selon la revendication 2, dans lequel la deuxième mémoire est adaptée, en outre, pour mémoriser (42) des adresses à destination du circuit esclave.

6. Dispositif selon l'une des revendications 2 ou 5, dans lequel la deuxième mémoire (42) est adaptée, en outre, pour mémoriser des mots de commande à destination du circuit esclave.

7. Dispositif selon l'une des revendications 1 à 6, dans lequel la machine d'état (43) programmable comporte :
- une mémoire d'état (51) dont le contenu correspond à des commandes et éventuellement des adresses à destination des première et/ou deuxième mémoires (41, 42) et des premier et/ou deuxième compteurs d'adresses (44, 45),
- un compteur d'état (52. 56) qui sert à adresser la mémoire d'état (51).
- une horloge programmable (50) dont la fréquence minimum est supérieure à la fréquence du signal d'échantillonnage.

8. Dispositif selon la revendication 7, dans lequel la machine d'état (43) comporte au moins un compteur de boucle (58) pour compter le nombre de fois où une séquence de lignes de la mémoire d'état est lue de manière répétée.

9. Dispositif selon l'une des revendications 7 ou 8, dans lequel la machine d'état comporte :
- une entrée pour recevoir un signal de disponibilité (R/B̅) provenant du circuit esclave,
- des moyens de neutralisation (55) de l'horloge programmable (50) pour stopper l'horloge programmable en réponse au signal de disponibilité (R/B) lorsque le signal de disponibilité indique l'indisponibilité (R/B̅) du circuit esclave.

10. Dispositif selon l'une des revendications 2 à 9, comportant, en outre, au moins un moyen de multiplexage (62) pour multiplexer au moins une sortie de donnée de la première mémoire (41) avec au moins une entrée/sortie de la deuxième mémoire (42).

11. Dispositif selon l'une des revendications 2 à 10, dans lequel, le circuit esclave étant une mémoire de type ROM programmable, le dispositif comporte :
- un bus de commande permettant de fournir des commandes de lecture ou d'écriture au circuit esclave, et
- un bus de données qui sert également de bus d'adresse et de bus de commande pour des commandes complexes.

12. Circuit intégré **caractérisé en ce qu'**il comporte un dispositif d'interface de commande selon l'une des revendications 1 à 11.

13. Système électronique comportant au moins :
- un processeur central (1) muni d'un bus central (2) pour échanger des données, des adresses et/ou des commandes avec d'autres circuits ;
- une mémoire (3) mémorisant au moins un jeu d'instructions complexes correspondant à au moins un circuit esclave, la mémoire étant couplée au bus central (2) ;
- un dispositif programmable d'interface selon l'une des revendications 1 à 11, ledit dispositif étant couplé au bus central (2)

14. Système selon la revendication 13 **caractérisé en ce qu'**il est réalisé sous la forme d'un système sur puce.

15. Procédé de commande d'un circuit esclave à l'aide d'un dispositif d'interface de commande programmable par un système ayant au moins un processeur central (1) et une mémoire (3) dans laquelle tout signal de commande destiné à commander le circuit esclave est décomposé en une succession de bits par échantillonnage à l'aide d'un signal d'échantillonnage dont la période est au plus égale à la plus petite durée entre deux changements d'état d'un signal de commande, le dispositif d'interface programmable comportant une première mémoire, un premier compteur d'adresse, et une machine d'état programmable, le procédé comportant les étapes suivantes :
- élaboration par le processeur d'une série de commandes en fonction de l'opération à effectuer dans le circuit esclave,
- élaboration par le processeur d'une succession d'états correspondant à la série de commandes, à partir des éléments présents dans la mémoire du système,
- chargement, sous la commande du processeur, de la succession d'états dans la première mémoire du dispositif d'interface de commande programmable, et
- après l'étape de chargement, contrôle de la première mémoire et du premier compteur par la machine d'état programmable, de manière à commander le circuit esclave suivant la succession d'états.

16. Procédé selon la revendication 15, dans lequel le dispositif d'interface de commande programmable comporte une deuxième mémoire et un deuxième compteur d'adresse, **caractérisé en ce qu'**il comporte les étapes suivantes :
- préalablement à l'étape de contrôle de la première mémoire et du premier compteur par la machine d'état programmable, chargement dans la deuxième mémoire du dispositif d'interface de commande programmable de données à écrire dans le circuit esclave,
- simultanément à l'étape de contrôle de la première mémoire et du premier compteur par la machine d'état programmable, contrôle de la deuxième mémoire et du deuxième compteur, par la machine d'état, de manière à fournir les données à écrire sur un bus de données.

17. Procédé selon la revendication 15, dans lequel le dispositif d'interface de commande programmable comporte une deuxième mémoire et un deuxième compteur d'adresse, **caractérisé en ce qu'**il comporte les étapes suivantes ;
- simultanément à l'étape de contrôle de la première mémoire et du premier compteur par la machine d'état programmable, contrôle de la deuxième mémoire et du deuxième compteur, par la machine d'état, de manière à recopier dans la deuxième mémoire des données provenant d'un bus de données du circuit esclave,
- après avoir effectué la totalité des états de la succession d'états, indication par la machine d'état au processeur qu'il peut procéder à un transfert de données depuis la deuxième mémoire du dispositif d'interface de commande programmable vers un autre circuit.

## Claims

1. Programmable control interface device (4) for control of a slave circuit by a system having at least one central processor (1) and one memory (3) in which any control signal (CLE, ALE, C̅E̅, R̅E̅, W̅E̅, W̅P̅) intended to control the slave circuit is decomposed into a succession of bits corresponding to a sampling of the said signal with the aid of a sampling signal, the period of which is at most equal to the smallest duration between two changes of state of a control signal, said device comprising:
- a first memory (41) adapted for storing, under the control of the processor, a sequence of sampled commands elaborated by the processor as a function of the operation to be executed in the slave circuit from elements present in the system memory,
- a first address counter (44) for supplying addresses to said first memory (41),
- a programmable state machine (43) for driving the first memory (41) and the first address counter (44) so as to control the slave circuit.

2. Device according to Claim 1, further comprising:
- a second memory (42) for storing data destined for or originating from the slave circuit,
- a second address counter (45) for supplying addresses to said second memory (42), the second address counter (45) being driven by the programmable state machine (43).

3. Device according to one of Claims 1 or 2, wherein the first memory (41) is adapted to store, furthermore, addresses destined for the slave circuit.

4. Device according to one of Claims 1 through 3, wherein the first memory (41) is adapted, furthermore, to store control words destined for the slave circuit.

5. Device according to Claim 2, wherein the second memory is adapted, furthermore, to store (42) addresses destined for the slave circuit.

6. Device according to one of Claims 2 or 5, wherein the second memory (42) is adapted, furthermore, to store control words destined for the slave circuit.

7. Device according to one of Claims 1 through 6, wherein the state machine comprises:
- a state memory (51) whose content corresponds to commands and possibly addresses destined for the first and/or second memories (41, 42) and first and/or second address counters (44, 45),
- a state counter (52, 56) which serves to address the state memory (51),
- a programmable clock (50) whose minimum frequency is greater than the frequency of the sampling signal.

8. Device according to Claim 7, wherein the state machine (43) comprises at least one loop counter (58) for counting the number of times that a line sequence of the state memory is read repeatedly.

9. Device according to one of Claims 7 or 8, wherein the state machine comprises:
- an input for receiving an availability signal (R/B̅) originating from the slave circuit,
- means (55) of neutralization of the programmable clock (50) for halting the programmable clock in response to the availability signal when the availability signal (R/B̅) indicates the unavailability of the slave circuit.

10. Device according to one of Claims 2 through 9, furthermore comprising at least one multiplexing means (62) for multiplexing at least one data output of the first memory (41) with at least one input/output of the second memory (42).

11. Device according to one of Claim 2 through 10, wherein the slave circuit being a memory of programmable ROM type, said device comprises:
- a command bus making it possible to supply read or write commands to the slave circuit, and
- a data bus which also serves as address bus and as command bus for complex commands.

12. Integrated circuit comprising a control interface device according to one of Claims 1 through 11.

13. Electronic system comprising at least:
- a central processor (1) furnished with a central bus (2) for exchanging data, addresses and/or commands with other circuits;
- a memory (3) storing at least one set of complex instructions corresponding to at least one slave circuit, the memory being coupled to the central bus (2),
- a programmable interface device according to one of Claims 1 through 11, said device being coupled to the central bus (2).

14. System according to Claim 13, wherein said system is embedded in the form of an on-chip system.

15. Method of control of a slave circuit with the aid of a programmable control interface device by a system having at least one central processor (1) and one memory (3) in which any control signal intended to control the slave circuit is decomposed into a succession of bits by sampling with the aid of a sampling signal, the period of said sampling signal being at most equal to the smallest duration between two changes of state of a control signal, the programmable interface device comprising a first memory, a first address counter, and a programmable state machine, said method comprising the following steps:
- elaboration by the processor of a series of commands as a function of the operation to be executed in the slave circuit,
- elaboration by the processor of a succession of states corresponding to the command series, from elements present in the system memory,
- loading, under control of the processor, of the succession of states into the first memory of the programmable control interface device, and
- after the loading step, to the controlling of the first memory and of the first counter by the programmable state machine, so as to control the slave circuit according to the succession of states.

16. Method according to Claim 15, the programmable control interface device comprising a second memory and a second address counter, wherein said method further comprises the following steps:
- prior to the step of controlling of the first memory and of the first counter by the programmable state machine,, loading into the second memory of the programmable control interface device of data to be written into the slave circuit,
- simultaneously with the step of controlling of the first memory and of the first counter by the programmable state machine, the controlling of the second memory and of the second counter, by the state machine, so as to supply the data to be written on a data bus.

17. Method according to Claim 15, wherein the programmable control interface device comprises a second memory and a second address counter, , **characterized in that** the method comprises the following steps:
- simultaneously with the step of controlling of the first memory and to the first counter by the programmable state machine, the controlling of the second memory and of the second counter, by the state machine, so as to copy into the second memory data originating from a data bus of the slave circuit,
- after having performed the entirety of the states of the succession of states, the informing by the state machine of the processor that it can proceed with a transfer of data from the second memory of the programmable control interface device to another circuit.

## Patentansprüche

1. Programmierbare Steuerschnittstellenvorrichtung (4) zum Steuern eines Slave-Schaltkreises durch ein System, das mindestens einen zentralen Prozessor (1) und einen Speicher (3) hat, in dem jedes Steuersignal (CLE, ALE, *C̅E̅*, *R̅E̅*, *W̅E̅, W̅P̅*), das dazu bestimmt ist, den Slave-Schaltkreis zu steuern, in eine Abfolge von Bits aufgeschlüsselt wird, die einem Abtasten des Signals mit Hilfe eines Abtastsignals entspricht, dessen Periode mindestens gleich der kleinsten Dauer zwischen zwei Zustandswechseln eines Steuersignals ist, wobei die Vorrichtung Folgendes aufweist:
- einen ersten Speicher (41), der unter der Steuerung des Prozessors eine Abfolge abgetasteter Steuerungen speichern kann, die von dem Prozessor in Abhängigkeit von dem in dem Slave-Schaltkreis durchzuführenden Vorgang ausgehend von Elementen, die in dem Speicher des Systems gegenwärtig sind, erstellt wird,
- einen ersten Adresszähler (44), um dem ersten Speicher (41) Adressen zu liefern,
- eine programmierbare Zustandsmaschine (43), um den ersten Speicher (41) und den ersten Adresszähler (44) so zu steuern, dass der Slave-Schaltkreis gesteuert wird.

2. Vorrichtung nach Anspruch 1, die ferner Folgendes aufweist:
- einen zweiten Speicher (42), um Daten für oder von dem Slave-schaltkreis zu speichern,
- einen zweiten Adresszähler (45), um dem zweiten Speicher (42) Adressen zu liefern, wobei der zweite Adresszähler (45) von der programmierbaren Zustandsmaschine (43) gesteuert wird.

3. Vorrichtung nach einem der Ansprüche 1 oder 2, bei der der erste Speicher (41) ferner Adressen für den Slave-Schaltkreis speichern kann.

4. vorrichtung nach einem der Ansprüche 1 bis 3, bei der der erste Speicher (41) ferner Steuerwörter für den Slave-Schaltkreis speichern kann.

5. Vorrichtung nach Anspruch 2, bei der der zweite Speicher (42) ferner Adressen für den Slave-Schaltkreis speichern kann.

6. Vorrichtung nach einem der Ansprüche 2 oder 5, bei der der zweite Speicher (42) ferner Steuerwörter für den Slave-Schaltkreis speichern kann.

7. Vorrichtung nach einem der Ansprüche 1 bis 6, bei der die programmierbare Zustandsmaschine (43) Folgendes aufweist :
- einen Zustandsspeicher (51), dessen Inhalt Steuerungen und eventuell Adressen für den ersten und/oder den zweiten Speicher (41, 42) und den ersten und/oder den zweiten Adresszähler (44, 45) entspricht,
- einen Zustandszähler (52, 56), der zum Adressieren des Zustandsspeichers (51) dient,
- einen programmierbaren Taktgeber (50), dessen Mindestfrequenz größer ist als die Frequenz des Abtastsignals.

8. Vorrichtung nach Anspruch 7, bei der die Zustandsmaschine (43) mindestens einen Schleifenzähler (58) aufweist, um die Anzahl Male zu zählen, die eine Zeilenabfolge des Zustandsspeichers wiederholt gelesen wird.

9. Vorrichtung nach einem der Ansprüche 7 oder 8, bei der die Zustandsmaschine Folgendes aufweist:
- einen Eingang, um ein Verfügbarkeltssignal (*R*/*B̅*) zu empfangen, das von dem Slave-Schaltkreis kommt,
- Neutralisierungsmittel (55) des programmierbaren Taktgebers (50), um den programmierbaren Taktgeber als Reaktion auf das Verfügbarkeitssignal (R/*B̅*) zu stoppen, wenn das Verfügbarkeitssignal die Unverfügbarkeit (R/*B̅*) des Slave-Schaltkreises anzeigt.

10. Vorrichtung nach einem der Ansprüche 2 bis 9, die ferner mindestens ein Multiplexmittel (62) aufweist, um mindestens einen Datenausgang des ersten Speichers (41) mit mindestens einem Eingang/Ausgang des zweiten Speichers (42) zu multiplexen.

11. Vorrichtung nach einem der Ansprüche 2 bis 10, bei der der Slave-Schaltkreis ein programmierbarer Speicher des Typs ROM ist, wobei die Vorrichtung Folgendes auf weist:
- einen Steuerbus, der es erlaubt, Lesebefehle oder Schreibbefehle zu dem Slave-Sckraltkreis zu liefern, und
- einen Datenbus, der auch als Adressbus und Steuerbus für komplexe Steuerungen dient.

12. Integrierter Schaltkreis, **dadurch gekennzeichnet, dass** er eine Steuerschnittstellenvorrichtung nach einem der Ansprüche 1 bis 11 aufweist.

13. Elektronisches System, das mindestens Folgendes aufweist:
- einen zentralen Prozessor (1), der mit einem zentralen Bus (2) versehen ist, um Daten, Adressen und/oder Steuerungen mit anderen Schaltkreisen auszutauschen;
- einen Speicher (3), der mindestens einen Satz komplexer Anweisungen speichert, die mindestens einem Slave-Schaltkreis entsprechen, wobei der Speicher mit dem zentralen Bus (2) gekoppelt ist;
- eine programmierbare Schnittstellenvorrichtung nach einem der Ansprüche 1 bis 11, wobei die Vorrichtung mit dem zentralen Bus (2) gekoppelt ist.

14. System nach Anspruch 13, **dadurch gekennzeichnet, dass** es in Form eines Systems auf Chip ausgeführt ist.

15. Steuerverfahren eines Slave-Schaltkreises mit Hilfe einer Steuerschnittstellenvorrichtung, die durch ein System programmierbar ist, das mindestens einen zentralen Prozessor (1) und einen Speicher (3) hat, in dem jedes Steuersignal, das dazu bestimmt ist, den Slave-Schaltkreis zu steuern, in eine Abfolge von Bits durch Abtasten mit Hilfe eines Abtastsignals, dessen Periode mindestens gleich der kleinsten Dauer zwischen zwei Zustandswechseln eines Steuersignals ist, aufgeschlüsselt wird, wobei die programmierbare Schnittstellenvorrichtung einen ersten Speicher, einen ersten Adresszähler und eine programmierbare Zustandsmaschine aufweist, wobei das Verfahren die folgenden Schritte aufweist:
- Erstellen durch den Prozessor einer Reihe von Steuerungen in Abhängigkeit von dem in dem Slave-Schaltkreis durchzuführenden Vorgang,
- Erstellen durch den Prozessor einer Abfolge von Zuständen, die der Reihe von Steuerungen entsprechen, ausgehend von Elementen, die in dem Speicher des Systems gegenwärtig sind,
- unter der Steuerung des Prozessors Laden der Abfolge von Zuständen in den ersten Speicher in der programmierbaren Steuerschnittstellenvorrichtung, und
- nach dem Ladeschritt Steuern des ersten Speichers und des ersten Zählers durch die programmierbare Zustandsmaschine, so dass der Slave-Schaltkreis gemäß der Abfolge von Zuständen gesteuert wird.

16. Verfahren nach Anspruch 15, bei dem die programmierbare Steuerschnittstellenvorrichtung einen zweiten Speicher und einen zweiten Adresszähler aufweist, **dadurch gekennzeichnet, dass** es die folgenden Schritte aufweist:
- vor dem Schritt des Steuern des ersten Speichers und des ersten Zählers durch die programmierbare Zustandsmaschine, Laden von Daten, die in den Slave-Schaltkreis zu schreiben sind, in den zweiten Speicher der programmierbaren Steuerschnittstellenvorrichtung,
- gleichzeitig mit dem Schritt des Steuerns des ersten Speichers und des Zählers durch die programmierbare Zustandsmaschine, Steuern des zweiten Speichers und des zweiten Zählers durch die Zustandsmaschine, um Daten zu liefern, die auf einen Datenbus zu schreiben sind.

17. Verfahren nach Anspruch 15, bei dem die programmierbare Steuerschnittstellenvorrichtung einen zweiten Speicher und einen zweiten Adresszähler aufweist, **dadurch gekennzeichnet, dass** es die folgenden Schritte aufweist:
- gleichzeitig mit dem Schritt des Steuerns des ersten Speichers und des ersten Zählers durch die programmierbare Zustandsmaschine, Steuern des zweiten Speichers und des zweiten Zählers durch die Zustandsmaschine, so dass Daten, die von einem Datenbus des Slave-Schaltkreises kommen, in den zweiten Datenspeicher kopiert werden,
- nach dem Durchführen sämtlicher Zustände der Abfolge von Zuständen, Anzeigen durch die Zustandsmaschine für den Prozessor, dass er einen Datentransfer von dem zweiten Speicher der programmierbaren Steuerschnittstellenvorrichtung zu einem anderen Schaltkreis vornehmen kann.
